# EUROPEAN PATENT SPECIFICATION

(11) **EP 3 113 311 B1**
(45) Date of publication and mention of the grant of the patent: **01.04.2026**
(21) Application number: 14883640.6
(22) Date of filing: 04.05.2014
(51) Int. Cl.: H02H 3/087, H02H 7/127, H02M 1/32, H02H 7/10, H02M 7/217, H05K 7/20, H02M 7/483, H02H 7/122, H02H 7/125

(54) **DIRECT-CURRENT POWER TRANSMISSION PROTECTION DEVICE, CONVERTER AND PROTECTION METHOD**
GLEICHSTROMÜBERTRAGUNGSSCHUTZVORRICHTUNG, WANDLER UND SCHUTZVERFAHREN
APPAREIL DE PROTECTION DE TRANSMISSION DE COURANT CONTINU, CONVERTISSEUR, ET PROCÉDÉ DE PROTECTION

(30) Priority: 27.02.2014 CN 201410069444
(43) Date of publication of application: 04.01.2017
(73) Proprietor: NR Electric Co., Ltd, Nanjing, Jiangsu 211102 (CN); NR Engineering Co., Ltd, Nanjing, Jiangsu 211102 (CN)
(72) Inventor: CAO, Dongming, Nanjing Jiangsu 211102 (CN); XIE, Yeyuan, Nanjing Jiangsu 211102 (CN); SHAO, Zhenxia, Nanjing Jiangsu 211102 (CN); LU, Yu, Nanjing Jiangsu 211102 (CN); LI, Min, Nanjing Jiangsu 211102 (CN); LIU, Haibin, Nanjing Jiangsu 211102 (CN); LI, Haiying, Nanjing Jiangsu 211102 (CN)
(74) Representative: Engelhard, Markus
(86) International application number: PCT/CN2014/076710
(87) International publication number: WO 2015/127716

(56) References cited:
- WO-A1-2012/000545
- WO-A1-2012/116738
- WO-A1-2013/060354
- CN-A- 103 001 520
- CN-A- 103 595 282
- PUTRUS G A ET AL: "Improving current sharing between parallel varistors", INDUSTRIAL ELECTRONICS, 2001. PROCEEDINGS. ISIE 2001. IEEE INTERNATION AL SYMPOSIUM ON JUNE 12-16, 2001, PISCATAWAY, NJ, USA,IEEE, PISCATAWAY, NJ, USA, vol. 2, 12 June 2001 (2001-06-12), pages 1324 - 1327, XP010548659, ISBN: 978-0-7803-7090-6

## Description

### TECHNICAL FIELD

The present invention relates to the field of direct-current power transmission, and in particular, to a protection device for a direct-current short circuit fault of flexible direct-current power transmission, a converter including the protection device and a protection method therefor.

### BACKGROUND ART

The direct-current power transmission technique (HVDC, High-Voltage Direct Current) is a transmission technique for transmitting electrical energy in form of direct current through alternating current/direct current and direct current/alternating current conversions by means of high-power half-controlled power electronic devices (such as thyristors) or fully-controlled power electronic devices (such as insulated gate bipolar transistors (IGBT) and integrated gate commutated thyristors (IGCT)). The direct-current power transmission using the half-controlled power electronic devices (thyristors) is called a current source converter-based direct-current power transmission system (CSC-HVDC), or is also called conventional direct-current power transmission. The direct-current power transmission using the fully-controlled power electronic devices (IGBT) is called a voltage source converter-based direct-current power transmission system (VSC-HVDC), or is also called flexible direct-current power transmission.

The direct-current power transmission system is high-voltage, high-current electrical equipment. Once a fault occurs, the equipment may suffer from loss due to over-voltage or over-current surges. Therefore, a proper protection measure is an indispensable part of the safe and reliable operation of the direct-current power transmission system.

Among various possible faults, direct-current side faults represented by direct-current transmission line faults are especially common. Direct-current transmission lines may probably reach thousands of kilometers and are exposed to the complex natural environment, and therefore have a maximum probability of fault occurrence. When a fault, such as short circuit, occurs on direct-current transmission lines, severe over-current may appear in the direct-current power transmission system, short circuit current needs to be suppressed in time, and the direct-current system needs to be assisted to be recovered from the fault to operate normally as soon as possible.

When a direct-current side short circuit fault occurs, a three-phase bridge type converter including thyristor devices used by conventional direct current can suppress direct-current short circuit current by rapidly controlling the firing angle of the thyristors. The specific method includes: when the direct-current short circuit fault occurs, the firing angle is controlled to immediately shift phases, so that direct-current voltage is rapidly reversed and that the direct-current short circuit current is rapidly suppressed; and after the arc of short circuit points is naturally extinguished, the normal control on the firing angle is recovered and the normal operation of the direct-current power transmission system is recovered. If the fault is a one-time transient fault, the direct-current power transmission system may maintain continuous normal operation; if the fault is a permanent short circuit fault, after system recovery, short circuit current may appear again, a direct-current power transmission control and protection system switches off an alternating-current incoming breaker according to a protection logic laid down in advance, and thereby the entire direct-current power transmission system is shut down. Fortunately, such a permanent fault only accounts for a very small proportion among direct-current transmission line faults, so the conventional direct-current power transmission system is rarely out of operation due to the short circuit of the direct-current transmission lines.

However, such a good protection method is not fully feasible in flexible direct-current power transmission. The flexible direct-current power transmission system adopts IGBTs to compose a voltage source converter, direct-current voltage therefore cannot be reversed by means of the control of the converter, and therefore the method cannot suppress short circuit current either. Then the measure of the flexible direct-current power transmission system in coping with the short circuit fault of direct-current transmission lines is directly switching off an alternating-current incoming breaker to shut down the entire direct-current power transmission system. After fault current attenuation is complete, charging and operation are resumed.

In actual projects, coping with the direct-current side short circuit fault at the cost of shutting down the system is not enough to protect the equipment of the flexible direct-current power transmission system well from safety threats:
(1) Diode devices are connected in parallel in the flexible direct-current power transmission converter, providing a loop for direct-current short circuit current when the direct-current short circuit fault occurs, the attenuation of the short circuit current in the direct-current loop is difficult due to the existence of the diodes even if the alternating-current incoming breaker is switched on, as a result, on one hand, the equipment will be exposed to high-current surges for a longer time, on the other hand, the whole system recovery time will be prolonged greatly, and consequently, economic loss and system destabilization risk will be exacerbated.
(2) When short circuit occurs, the equipment of the flexible direct-current power transmission system, such as inductors and capacitors, may oscillate short circuit current, which further increases the destructive power of the short circuit current on equipment and peripheral systems.

A most direct solution is to add a direct-current breaker to the direct-current loop, and when the short circuit fault occurs, the direct-current breaker immediately cuts off direct-current short circuit current. However, because the technical maturity of the equipment is not enough for engineering application, the equipment still cannot be adopted for a long time. Even if the application technique becomes mature in the future, the equipment thereof is complex and has a high manufacturing cost, a great workload of operation and maintenance, and a poor economic efficiency.

WO 2013/060354 Al describes a switching unit of a converter module that is replaced by a bidirectional switch.

WO 2012/000545 Al describes an HVDC converter station for interconnection of a DC transmission line and an AC system of at least one AC phase. The HVDC converter station comprises a VSC converter and a DC breaker connected in series between the VSC converter and the DC transmission line. The HVDC converter station comprises a protection system configured to monitor the temperature of a reverse-conducting component of the reverse-conducting switch arrangement, and trigger the opening of the DC breaker if the temperature of the reverse-conducting component exceeds a temperature threshold.

CN 103 001 520 A describes a modularized multi-level three-phase voltage source converter. The modularized multi-level three-phase voltage source converter comprises six current converting arms and six filter reactors.

CN 103 595 282 A describes a current conversion module circuit of a modularized multi-level current converter. The current conversion module circuit of the modularized multi-level current converter comprises a direct current capacitor, a clamping diode, a second clamping diode, semiconductor switches and a fly-wheel diode.

### SUMMARY OF THE INVENTION

An objective of the present invention is to provide a converter capable of effectively resolving the inherent disadvantages of difficult short circuit current attenuation and oscillation in a flexible direct-current power transmission system and being easy to implement and good in economic efficiency.

In order to achieve the objective, the present invention provides a converter as defined in claim 1.

Further optional features of the invention are defined in the dependent claims.

Further, the switching transistor is a power semiconductor device with a turn-off function.

Further, an IGBT is adopted as the bidirectional circulation current switch, a collector of the IGBT serves as an anode of the bidirectional circulation current switch, and an emitter of IGBT serves as a cathode of the bidirectional circulation current switch;
or at least one IGCT or at least one GTO is adopted to form the bidirectional circulation current switch, an anode of the IGCT or GTO serves as an anode of the bidirectional circulation current switch, and a cathode of the IGCT or GTO serves as a cathode of the bidirectional circulation current switch;
or an MOSFET is adopted to form the bidirectional circulation current switch, a drain of the MOSFET serves as an anode of the bidirectional circulation current switch, and a source of the MOSFET serves as a cathode of the bidirectional circulation current switch.

Further, the protection device is also provided with a corresponding cooling device.

Further, the protection device also comprises a parallel-connection voltage protection element between the anode and cathode of the protection device.

Further, the protection device also comprises a parallel-connection bypass switch element between the anode and cathode of the protection device.

Further, a value range of the resistor R is between 0.1ohm and 100ohm.

Further, connecting at least one protection device in series specifically means that the at least one protection device is connected in series between the reactor and the submodule, or is connected in series between the reactor and the midpoint, or is connected in series between the two submodules, or is connected in series between the submodule and the positive terminal of the converter, or is connected in series between the submodule and the negative terminal of the converter, or is connected in series at all the foregoing positions on the upper bridge arm and the lower bridge arm.

Further, the numbers of the protection devices connected in series in each phase unit are equal.

Further, the converter is characterized in that the converter is applicable to a voltage source topology, and may be a modularized multi-level flexible direct-current system, a two-level flexible direct-current system or a three-level flexible direct-current system.

The present invention has the beneficial effects that the present invention provides the protection device, the converter and the protection method for flexible direct-current power transmission, which can rapidly and effectively suppress direct-current short circuit current and damp current oscillation, and not only can better protect equipment safety, but also can greatly shorten fault current attenuation time, thus shortening direct-current shutdown time and further decreasing economic loss and system destabilization risk caused by shutdown to the max. Moreover, the protection device is structurally simple and low in cost, and has good implementability and economic efficiency.

### BRIEF DESCRIPTION OF THE DRAWINGS

Fig. 1 is a modularized multi-level flexible direct-current power transmission topology;
Fig. 2 is a unit structure diagram of a protection device;
Fig. 3 is a structural schematic diagram of a converter comprising the protection devices; and
Fig. 4 is a schematic diagram of a short circuit fault of the converter comprising the protection devices.

### DETAILED DESCRIPTION OF THE INVENTION

In reference to the drawings, the technical solution of the present invention is described in detail below.

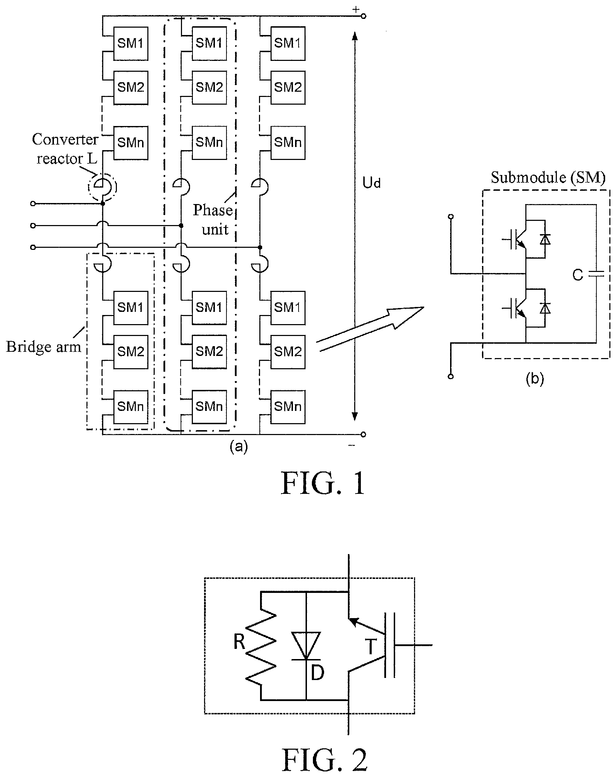

Fig. 1 shows the topological structure of a converter. The converter includes three phases, each phase comprises an upper bridge arm and a lower bridge arm, and the converter comprises six bridge arms in total. A reactor L and N submodules SM are connected in series to form each bridge arm, and the upper bridge arm and lower bridge arm of each phase are combined together to form a phase unit. A joint of the upper bridge arm and the lower bridge arm is a midpoint. Leading-out terminals of the three upper bridge arms are connected together to serve as a positive terminal of the converter; and the leading-out terminals of the three lower bridge arms are connected together to serve as a negative terminal of the converter.

The present invention provides a protection device, which comprises a resistor unit and a bidirectional circulation current switch unit, and the resistor unit and the bidirectional circulation current switch unit are connected in parallel to form the protection device. The resistor unit may be one resistor, or may be formed by a plurality of resistors cascaded in a way of serial connection or parallel connection. Likewise, the bidirectional circulation current switch unit may also be formed by cascading at least one bidirectional circulation current switch.

Further, a diode unit and a switching transistor unit are connected in parallel to form the bidirectional circulation current switch. An anode of the switching transistor unit, a cathode of the diode unit and one end of the resistor unit are connected together, defined as a positive terminal of the protection device. A cathode of the switching transistor unit, an anode of the diode unit and the other end of the resistor unit are connected together, defined as a negative terminal of the protection device. At least one diode is cascaded to form the diode unit, and at least one switching transistor is cascaded to form the switching transistor unit. The switching transistor is a power semiconductor device with a turn-off function.

An IGBT also may be adopted as the bidirectional circulation current switch, a collector of the IGBT serves as an anode of the bidirectional circulation current switch, and an emitter of the IGBT serves as a cathode of the bidirectional circulation current switch.

Alternatively, at least one IGCT or at least one GTO plus other auxiliary devices is adopted to form the bidirectional circulation current switch, an anode of the IGCT or gate-turn-off thyristor (GTO) serves as an anode of the bidirectional circulation current switch, and a cathode of the IGCT or GTO serves as a cathode of the bidirectional circulation current switch.

Alternatively, the bidirectional circulation current switch may also be composed of an MOSFET plus other auxiliary devices, a drain of the metal-oxide-semiconductor field-effect transistor (MOSFET) serves as an anode of the bidirectional circulation current switch, and a source of the MOSFET serves as a cathode of the bidirectional circulation current switch.

In addition, the current of the bridge arms may flow through the switching transistors of the protection devices, so the protection device may also be provided with a corresponding cooling device. Preferably, water cooling radiation may be adopted.

In addition, a voltage protection element may also be connected in parallel between the anode and cathode of the protection device to suppress the over-voltage of both ends of the switch.

In addition, a bypass switch element may also be connected in parallel between the anode and cathode of the protection device in order to conveniently cut off the protection device.

In addition, a value range of the resistor R in the protection device is between 0.1ohm and 100ohm.

Fig. 2 shows a preferred embodiment of the protection device in the converter according to the invention, which protection device includes a resistor, a switching transistor and a diode. An anode of a switching transistor T, a cathode of a diode and one end of a resistor are connected together, defined as a positive terminal of the protection device, and a cathode of the switching transistor T, an anode of the diode and the other end of the resistor are connected together, defined as a negative terminal of the protection device.

According to the invention, the resistor unit is formed by a plurality of resistors constructed in a cascading way such as serial connection and parallel connection, but is not limited to an actual resistor. Likewise, the switching transistor is formed by a plurality of cascaded switching transistors, and the diode is formed by a plurality of cascaded diodes. Fig. 2 is an equivalent circuit diagram of the protection device.

The converter according to the invention includes the protection device. The converter includes three phases, each phase includes an upper bridge arm and a lower bridge arm, and a reactor unit and at least one submodule are connected in series to form each bridge arm. The upper bridge arm and the lower bridge arm of each phase are combined together to form a phase unit, a joint of the upper bridge arm and the lower bridge arm is a midpoint, and leading-out terminals of the three upper bridge arms are connected together to serve as a positive terminal of the converter; the leading-out terminals of the three lower bridge arms are connected together to serve as a negative terminal of the converter; and the converter is characterized in that at least one protection device is connected in series in each phase unit.

Preferably, the numbers of the protection devices connected in series in each phase units are equal.

The protection devices may be connected in series at any positions in the phase units, and for example, the protection devices may be connected in series between the reactor and the submodules or is connected in series between the reactor and the midpoint, or is connected in series between the two submodules, or is connected in series between the submodule and the positive terminal of the converter, or is connected in series between the submodule and the negative terminal of the converter.

Moreover, the protection devices may be separately connected in series in the upper bridge arms or the lower bridge arms, or may be connected in series at symmetric or asymmetric positions in the upper bridge arms and the lower bridge arms.

The protection devices connected in series in the phase units may be connected in series at corresponding or non-corresponding positions.

The converter may be a modularized multi-level flexible direct-current system, a two-level flexible direct-current system or a three-level flexible direct-current system.

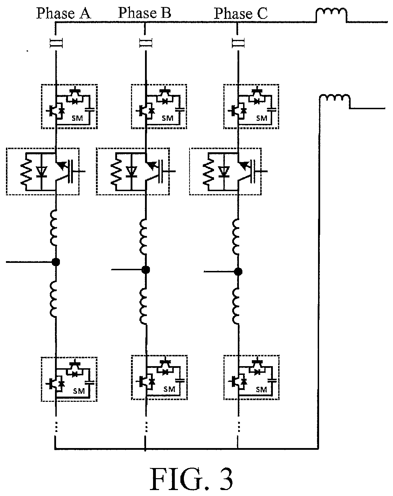

A preferred embodiment as shown in Fig. 3 means that the protection devices are connected in series in the converter given by Fig. 1, and one protection device is connected in series between the submodule and the reactor of each of the three upper bridge arms.

The serial connection mode of the protection devices in the converter provided in the present invention is a serial connection at the alternating-current side of the converter. Thus, the beneficial effects are as follows: (1) The protection device and the converter may be designed integrally, having good engineering implementability and saving spaces. The protection device may adopt a modularized design concept and may readily adopt standardized design and assembly together with the submodule of the converter. The shape, size and wiring of the protection device are consistent with those of the submodule, the protection device is directly installed in the converter, and therefore does not occupy an extra space, and this advantage is very important in flexible direct-current power transmission projects highly stressing the compact design. (2) Separate energy access is not required. The switching transistor in the protection device and a control loop thereof need proper power supply, and are installed at the alternating-current side, and the protection devices may share an energy access loop with a converter valve. (3) The protection device may share a cooling device with other devices rather than be equipped with a separate cooling device. The high-power power electronic device in the protection device needs to be cooled by water cooling circulation, and is installed at the alternating-current side of the converter valve, and the protection device may share a water cooling device with the converter valve. (4) The structure is simple, the size is small, and the cost is low. Compared with the direct-current side, the effective current value of the alternating-current side is small, and the switching transistor of the same model in the converter, rather than a multi-switching transistor parallel structure adopted to increase the rated current value, may be chosen as the switching transistor of the protection device. (5) The effect of suppressing current oscillation is better. Theoretical analysis and an experiment result show that the protection device connected in series at the alternating-current side of the converter has a good suppression effect on current oscillation at the initial stage of a fault, and can effectively suppress the fault current peak of the bridge arms and decrease the current stress of the submodules of the whole bridge arms.

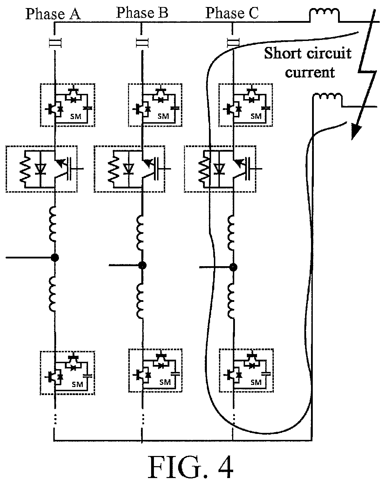

For the converter including the protection device provided in the present invention, when the positive terminal of the converter is short-circuited with the transmission line or other equipment connected with the cathode, high short circuit current may flow through the respective bridge arms, plus influences by capacitors and inductors in the whole loop, the short circuit current may further be oscillated, and as a result, the safety of the entire system equipment is endangered severely. Fig. 4 is a schematic diagram of the occurring short-circuiting.

A corresponding protection method includes the following steps:
(1) Detect and determine whether a direct-current side short circuit fault occurs, and if so, go to step (2).
(2) Apply a turn-off signal to bidirectional circulation current switches of all protection devices connected in series in the bridge arms.
(3) Detect and determine whether fault current attenuation is complete, and if so, go to step (4).
(4) Recover the operation of the flexible direct-current power transmission system.

Cascading connection called in the present invention includes connection modes such as serial connection and parallel connection.

The foregoing embodiments are merely intended to illustrate the technical idea of the present invention, and cannot limit the protection scope of the present invention, and any modifications which are made within the scope of the appended claims shall fall into the protection scope of the present invention.

## Claims

1. A converter, comprising:
three phases, wherein each phase comprises an upper bridge arm and a lower bridge arm, and wherein a reactor unit (L) and at least one submodule (SM1,...,SMn) are connected in series to form each bridge arm;
wherein the upper bridge arm and the lower bridge arm of each phase are combined together to form a phase unit, a joint of the upper bridge arm and the lower bridge arm is a midpoint, and leading-out terminals of the three upper bridge arms are connected together to serve as a positive terminal of the converter;
wherein the leading-out terminals of the three lower bridge arms are connected together to serve as a negative terminal of the converter;
**characterized in that** the converter further comprises a direct-current power transmission protection device that is connected in series in each phase unit,
wherein the at least one submodule (SM1,...,SMn) comprising a first submodule arm and a second submodule arm connected in parallel,
wherein the first submodule arm consists of a first submodule circuit, the first submodule circuit consisting of a first submodule diode connected in parallel with a first submodule switching transistor,
wherein the second submodule arm consists of a second submodule circuit and a submodule capacitor connected in series with the second submodule circuit, the second submodule circuit consisting of a second submodule diode connected in parallel with a second submodule switching transistor, and
wherein, the protection device comprises:
a resistor unit, and
a bidirectional circulation current switch unit,
the resistor unit and the bidirectional circulation current switch unit being connected in parallel to form the protection device,
wherein the bidirectional circulation current switch unit is formed by a bidirectional circulation current switch,
wherein a diode unit and a switching transistor unit are connected in parallel to form the bidirectional circulation current switch,
wherein the switching transistor unit is formed by a plurality of switching transistors cascaded in the way of serial connection or parallel connection,
wherein the diode unit is formed by a plurality of diodes cascaded in a way of serial connection or parallel connection, and
wherein the resistor unit is formed by a plurality of resistors cascaded in a way of serial connection or parallel connection.

2. The converter of claim 1, **characterized in that** an anode of the switching transistor unit, a cathode of the diode unit and one end of the resistor unit are connected together, defined as a positive terminal of the protection device;
a cathode of the switching transistor unit, an anode of the diode unit and the other end of the resistor unit are connected together, defined as a negative terminal of the protection device;
wherein an IGBT is adopted as the bidirectional circulation current switch, a collector of the IGBT serves as an anode of the bidirectional circulation current switch, and an emitter of IGBT serves as a cathode of the bidirectional circulation current switch;
or at least one IGCT or at least one GTO is adopted to form the bidirectional circulation current switch, an anode of the IGCT or the GTO serves as an anode of the bidirectional circulation current switch, and a cathode of the IGCT or the GTO serves as a cathode of the bidirectional circulation current switch;
or an MOSFET is adopted to form the bidirectional circulation current switch, a drain of the MOSFET serves as an anode of the bidirectional circulation current switch, and a source of the MOSFET serves as a cathode of the bidirectional circulation current switch.

3. The converter of claim 2, **characterized in that** the switching transistor is a power semiconductor device with a turn-off function.

4. The converter of claim 1, **characterized by** also being provided with a corresponding cooling device.

5. The converter of claim 1, **characterized by** also comprising a voltage protection element connected in parallel between the anode and the cathode of the protection device.

6. The converter of claim 1, **characterized by** also comprising a bypass switch element connected in parallel between the anode and the cathode of the protection device.

7. The converter of claim 1, **characterized in that** a value range of the resistor R is between 0.1ohm and 100ohm.

8. The converter of claim 1, **characterized in that** connecting the at least one protection device in series specifically means that the at least one protection device is connected in series between the reactor (L) and the submodule (SM1,...,SMn), or is connected in series between the reactor (L) and the midpoint, or is connected in series between two submodules (SM1,...,SMn), or is connected in series between the submodule (SM1,...,SMn) and the positive terminal of the converter, or is connected in series between the submodule (SM1,...,SMn) and the negative terminal of the converter, or is connected in series at all the foregoing positions on the upper bridge arm and the lower bridge arm.

9. The converter of claim 1 or claim 8, **characterized in that** the numbers of the protection devices connected in series in each phase units are equal.

10. The converter of claim 1, **characterized in that** the converter is applicable to a voltage source topology, and is a modularized multi-level flexible direct-current system, a two-level flexible direct-current system or a three-level flexible direct-current system.

11. A protection method of the converter of claim 1, comprising the following steps:
detecting and determining whether a direct-current side short circuit fault occurs, and if so, applying a turn-off signal to the bidirectional circulation current switches of all the protection devices connected in series in the bridge arms; and after fault current attenuation is complete, recovering system operation.

## Patentansprüche

1. Ein Wandler, umfassend:
drei Phasen, wobei jede Phase einen oberen Brückenarm und einen unteren Brückenarm umfasst, und wobei eine Reaktoreinheit (L) und mindestens ein Submodul (SM1, ..., SMn) in Reihe geschaltet sind, um jeden Brückenarm zu bilden;
wobei der obere Brückenarm und der untere Brückenarm jeder Phase miteinander kombiniert sind, um eine Phaseneinheit zu bilden, eine Verbindung des oberen Brückenarms und des unteren Brückenarms ein Mittelpunkt ist, und Ausgangsanschlüsse der drei oberen Brückenarme miteinander verbunden sind, um als ein positiver Anschluss des Wandlers zu dienen;
wobei die Ausgangsanschlüsse der drei unteren Brückenarme miteinander verbunden sind, um als ein negativer Anschluss des Wandlers zu dienen;
**dadurch gekennzeichnet, dass** der Wandler ferner eine Gleichstromleistungsübertragungsschutzvorrichtung umfasst, die in jeder Phaseneinheit in Reihe geschaltet ist,
wobei das mindestens eine Submodul (SM1, ..., SMn) ersten Submodularm und einen zweiten Submodularm umfasst, die parallel geschaltet sind,
wobei der erste Submodularm aus einer ersten Submodulschaltung besteht, wobei die erste Submodulschaltung aus einer ersten Submoduldiode besteht, die mit einem ersten Submodulschalttransistor parallel geschaltet ist,
wobei der zweite Submodularm aus einer zweiten Submodulschaltung und einem Submodulkondensator besteht, der mit der zweiten Submodulschaltung in Reihe geschaltet ist, wobei die zweite Submodulschaltung aus einer zweiten Submoduldiode besteht, die mit einem zweiten Submodulschalttransistor parallel geschaltet ist, und
wobei die Schutzvorrichtung umfasst:
eine Widerstandseinheit, und
eine bidirektionale Zirkulationsstromschalteinheit,
wobei die Widerstandseinheit und die bidirektionale Zirkulationsstromschalteinheit parallel geschaltet sind, um die Schutzvorrichtung zu bilden,
wobei die bidirektionale Zirkulationsstromschalteinheit durch einen bidirektionalen Zirkulationsstromschalter gebildet ist,
wobei eine Diodeneinheit und eine Schalttransistoreinheit parallel geschaltet sind, um den bidirektionalen Zirkulationsstromschalter zu bilden,
wobei die Schalttransistoreinheit durch mehrere Schalttransistoren gebildet ist, die in der Art einer Reihenschaltung oder Parallelschaltung kaskadiert sind,
wobei die Diodeneinheit durch mehrere Dioden gebildet ist, die in der Art einer Reihenschaltung oder Parallelschaltung kaskadiert sind, und
wobei die Widerstandseinheit durch mehrere Widerstände gebildet ist, die in der Art einer Reihenschaltung oder Parallelschaltung kaskadiert sind.

2. Der Wandler nach Anspruch 1, **dadurch gekennzeichnet, dass** eine Anode der Schalttransistoreinheit, eine Kathode der Diodeneinheit und ein Ende der Widerstandseinheit miteinander verbunden sind, die als ein positiver Anschluss der Schutzvorrichtung definiert sind;
eine Kathode der Schalttransistoreinheit, eine Anode der Diodeneinheit und das andere Ende der Widerstandseinheit miteinander verbunden sind, die als ein negativer Anschluss der Schutzvorrichtung definiert sind;
wobei ein IGBT als der bidirektionale Zirkulationsstromschalter verwendet wird, ein Kollektor des IGBT als eine Anode des bidirektionalen Zirkulationsstromschalters dient, und ein Emitter des IGBT als eine Kathode des bidirektionalen Zirkulationsstromschalters dient;
oder mindestens ein IGCT oder mindestens ein GTO verwendet wird, um den bidirektionalen Zirkulationsstromschalter zu bilden, eine Anode des IGCT oder des GTO als eine Anode des bidirektionalen Zirkulationsstromschalters dient, und eine Kathode des IGCT oder des GTO als eine Kathode des bidirektionalen Zirkulationsstromschalters dient;
oder ein MOSFET verwendet wird, um den bidirektionalen Zirkulationsstromschalter zu bilden, ein Drain des MOSFET als eine Anode des bidirektionalen Zirkulationsstromschalters dient, und eine Source des MOSFET als eine Kathode des bidirektionalen Zirkulationsstromschalters dient.

3. Der Wandler nach Anspruch 2, **dadurch gekennzeichnet, dass** der Schalttransistor eine Leistungshalbleitervorrichtung mit einer Abschaltfunktion ist.

4. Der Wandler nach Anspruch 1, **dadurch gekennzeichnet, dass** er auch mit einer entsprechenden Kühlvorrichtung versehen ist.

5. Der Wandler nach Anspruch 1, **dadurch gekennzeichnet, dass** er auch ein Spannungsschutzelement umfasst, das zwischen der Anode und der Kathode der Schutzvorrichtung parallel geschaltet ist.

6. Der Wandler nach Anspruch 1, **dadurch gekennzeichnet, dass** er auch ein Bypassschaltelement umfasst, das zwischen der Anode und der Kathode der Schutzvorrichtung parallel geschaltet ist.

7. Der Wandler nach Anspruch 1, **dadurch gekennzeichnet, dass** ein Wertebereich des Widerstands R zwischen 0,1 Ohm und 100 Ohm liegt.

8. Der Wandler nach Anspruch 1, **dadurch gekennzeichnet, dass** das Verbinden der mindestens einen Schutzvorrichtung in Reihe insbesondere bedeutet, dass die mindestens eine Schutzvorrichtung zwischen der Reaktoreinheit (L) und dem Submodul (SM1, ..., SMn) in Reihe geschaltet ist, oder zwischen der Reaktoreinheit (L) und dem Mittelpunkt in Reihe geschaltet ist, oder zwischen zwei Submodulen (SM1, ..., SMn) in Reihe geschaltet ist, oder zwischen dem Submodul (SM1, ..., SMn) und dem positiven Anschluss des Wandlers in Reihe geschaltet ist, oder zwischen dem Submodul (SM1, ..., SMn) und dem negativen Anschluss des Wandlers in Reihe geschaltet ist, oder an allen vorhergehenden Positionen auf dem oberen Brückenarm und dem unteren Brückenarm in Reihe geschaltet ist.

9. Der Wandler nach Anspruch 1 oder Anspruch 8, **dadurch gekennzeichnet, dass** die Anzahlen der Schutzvorrichtungen, die in jeder Phaseneinheit in Reihe geschaltet sind, gleich sind.

10. Der Wandler nach Anspruch 1, **dadurch gekennzeichnet, dass** der Wandler auf eine Spannungsquellentopologie anwendbar ist und ein modularisiertes mehrstufiges flexibles Gleichstromsystem, ein zweistufiges flexibles Gleichstromsystem oder ein dreistufiges flexibles Gleichstromsystem ist.

11. Ein Schutzverfahren des Wandlers nach Anspruch 1, umfassend die folgenden Schritte:
Erfassen und Bestimmen, ob ein gleichstromseitiger Kurzschlussfehler auftritt, und wenn dies der Fall ist, Anlegen eines Abschaltsignals an die bidirektionalen Zirkulationsstromschalter aller Schutzvorrichtungen, die in den Brückenarmen in Reihe geschaltet sind; und nachdem die Fehlerstromdämpfung abgeschlossen ist, Wiederherstellen des Systembetriebs.

## Revendications

1. Convertisseur, comprenant :
trois phases, dans lequel chaque phase comprend un bras de pont supérieur et un bras de pont inférieur, et dans lequel une unité de réacteur (L) et au moins un sous-module (SM1, ..., SMn) sont connectés en série pour former chaque bras de pont ;
dans lequel le bras de pont supérieur et le bras de pont inférieur de chaque phase sont combinés ensemble pour former une unité de phase, une jonction du bras de pont supérieur et du bras de pont inférieur est un point médian, et les bornes de sortie des trois bras de pont supérieurs sont connectées ensemble pour servir de borne positive du convertisseur ;
dans lequel les bornes de sortie des trois bras de pont inférieurs sont connectées ensemble pour servir de borne négative du convertisseur ;
**caractérisé en ce que** le convertisseur comprend en outre un dispositif de protection de transmission de puissance continue qui est connecté en série dans chaque unité de phase,
dans lequel l'au moins un sous-module (SM1, ..., SMn) comprend un premier bras de sous-module et un deuxième bras de sous-module connectés en parallèle,
dans lequel le premier bras de sous-module est constitué d'un premier circuit de sous-module, le premier circuit de sous-module étant constitué d'une première diode de sous-module connectée en parallèle avec un premier transistor de commutation de sous-module, dans lequel le deuxième bras de sous-module est constitué d'un deuxième circuit de sous-module et d'un condensateur de sous-module connecté en série avec le deuxième circuit de sous-module, le deuxième circuit de sous-module étant constitué d'une deuxième diode de sous-module connectée en parallèle avec un deuxième transistor de commutation de sous-module, et
dans lequel le dispositif de protection comprend :
une unité de résistance, et
une unité de commutation de courant de circulation bidirectionnelle,
l'unité de résistance et l'unité de commutation de courant de circulation bidirectionnelle étant connectées en parallèle pour former le dispositif de protection,
dans lequel l'unité de commutation de courant de circulation bidirectionnelle est formée par un commutateur de courant de circulation bidirectionnel,
dans lequel une unité de diode et une unité de transistor de commutation sont connectées en parallèle pour former le commutateur de courant de circulation bidirectionnel,
dans lequel l'unité de transistor de commutation est formée par une pluralité de transistors de commutation montés en cascade à la manière d'une connexion sérielle ou d'une connexion parallèle,
dans lequel l'unité de diode est formée par une pluralité de diodes montées en cascade à la manière d'une connexion sérielle ou d'une connexion parallèle, et
dans lequel l'unité de résistance est formée par une pluralité de résistances montées en cascade à la manière d'une connexion sérielle ou d'une connexion parallèle.

2. Convertisseur selon la revendication 1, **caractérisé en ce qu'**une anode de l'unité de transistor de commutation, une cathode de l'unité de diode et une extrémité de l'unité de résistance sont connectées ensemble, définies comme une borne positive du dispositif de protection ;
une cathode de l'unité de transistor de commutation, une anode de l'unité de diode et l'autre extrémité de l'unité de résistance sont connectées ensemble, définies comme une borne négative du dispositif de protection ;
dans lequel un transistor bipolaire à porte isolée, IGBT, est adopté en tant que le commutateur de courant de circulation bidirectionnel, un collecteur de l'IGBT sert d'anode du commutateur de courant de circulation bidirectionnel, et un émetteur de l'IGBT sert de cathode du commutateur de courant de circulation bidirectionnel ; ou
au moins un thyristor à commutation par gâchette intégrée, IGCT, ou au moins un thyristor à extinction par la gâchette, GTO, est adopté pour former le commutateur de courant de circulation bidirectionnel, une anode de l'IGCT ou du GTO sert d'anode du commutateur de courant de circulation bidirectionnel, et une cathode de l'IGCT ou du GTO sert de cathode du commutateur de courant de circulation bidirectionnel ; ou
un transistor à effet de champ de semi-conducteur d'oxyde de métal, MOSFET, est adopté pour former le commutateur de courant de circulation bidirectionnel, un drain du MOSFET sert d'anode du commutateur de courant de circulation bidirectionnel, et une source du MOSFET sert de cathode du commutateur de courant de circulation bidirectionnel.

3. Convertisseur selon la revendication 2, **caractérisé en ce que** le transistor de commutation est un dispositif semi-conducteur de puissance avec une fonction de coupure.

4. Convertisseur selon la revendication 1, **caractérisé en ce qu'**il est également doté d'un dispositif de refroidissement correspondant.

5. Convertisseur selon la revendication 1, **caractérisé en ce qu'**il comprend également un élément de protection de tension connecté en parallèle entre l'anode et la cathode du dispositif de protection.

6. Convertisseur selon la revendication 1, **caractérisé en ce qu'**il comprend également un élément de commutation de dérivation connecté en parallèle entre l'anode et la cathode du dispositif de protection.

7. Convertisseur selon la revendication 1, **caractérisé en ce que** la plage de valeurs de la résistance R est comprise entre 0,1 ohm et 100 ohms.

8. Convertisseur selon la revendication 1, **caractérisé en ce que** la connexion en série de l'au moins un dispositif de protection signifie spécifiquement que l'au moins un dispositif de protection est connecté en série entre la bobine de réactance (L) et le sous-module (SM1, ..., SMn), ou est connecté en série entre la bobine de réactance (L) et le point médian, ou est connecté en série entre deux sous-modules (SM1, ..., SMn), ou est connecté en série entre le sous-module (SM1, ..., SMn) et la borne positive du convertisseur, ou est connecté en série entre le sous-module (SM1, ..., SMn) et la borne négative du convertisseur, ou est connecté en série à toutes les positions précédentes sur le bras de pont supérieur et le bras de pont inférieur.

9. Convertisseur selon la revendication 1 ou 8, **caractérisé en ce que** les dispositifs de protection connectés en série dans chaque unité de phase sont en nombres identiques.

10. Convertisseur selon la revendication 1, **caractérisé en ce que** le convertisseur est applicable à une topologie de source de tension, et est un système à courant continu flexible multi-niveau modularisé, un système à courant continu flexible à deux niveaux ou un système à courant continu flexible à trois niveaux.

11. Procédé de protection du convertisseur selon la revendication 1, comprenant les étapes suivantes comprenant le fait de :
détecter et déterminer si un défaut de court-circuit côté courant continu se produit, et si tel est le cas, appliquer un signal de coupure aux commutateurs de courant de circulation bidirectionnels de tous les dispositifs de protection connectés en série dans les bras de pont ; et une fois l'atténuation du courant de défaut terminée, rétablir le fonctionnement du système.
